# EUROPÄISCHE PATENTSCHRIFT

(11) **EP 0 373 394 B1**
(45) Veröffentlichungstag und Bekanntmachung des Hinweises auf die Patenterteilung: **03.08.1994**
(21) Anmeldenummer: 89121579.0
(22) Anmeldetag: 21.11.1989
(51) Int. Cl.: G01R 23/09, G01P 5/00, G01S 17/58

(54) **Verfahren zur Bestimmung der Frequenz kurzer Schwingungspakete elektrischer Signale**
Method for the determination of the frequency of short bursts of electric signals
Procédé pour la détermination de la fréquence de brefs paquets d'ondes de signaux électriques

(30) Priorität: 28.11.1988 DE 3840109
(43) Veröffentlichungstag der Anmeldung: 20.06.1990
(73) Patentinhaber: Deutsch-Französisches Forschungsinstitut Saint-Louis, 68301 Saint-Louis Cédex (FR)
(72) Erfinder: Damp, Stephan, D-7858 Weil am Rhein (DE)
(74) Vertreter: Schwabe - Sandmair - Marx

(56) Entgegenhaltungen:
- REVIEW OF SCIENTIFIC INSTRUMENTS, Band 53, Nr. 5, Mai 1982, Seiten 656-661; J.C. FANTON et al.: "Versatile microprocessor data logging and processing system for laser Doppler anemometry"
- J. PHYS. E. SCIENT. INSTRUM., Band 10, Nr. 8, August 1977, Seiten 811-813; I. TAI et al.: "Digital frequency meter for burst-like laser Doppler signals"
- MESSEN + PRÜFEN, Nrs. 7/8, Juli/August 1978, Seiten 436-438; H.J. HAAG: "Transientenspeicher - ein Beitrag zu morderner Oszilloskopie"
- REV. SCI. INSTRUM., Band 47, Nr. 6, Juni 1976, Seiten 708-711; H.T. KALB et al.: "New technique in the processing and handling of laser velocimeter burst data"
- INTERNATIONAL JOURNAL OF ELECTRONICS, Band 62, Nr. 1, Januar 1987, Seiten 93-95; A.A. KHAN et al.: "Simple attachment to analogue/digital multimeter for frequency measurement up to 10 MHz"

## Beschreibung

Die Erfindung betrifft ein Verfahren zur Bestimmung der mittleren Frequenz periodischer elektrischer Signale innerhalb kurzer, statistisch unabhängig aufeinanderfolgender Schwingungspakete mit Hilfe von Komponenten, die für die Frequenzbestimmung zeitlich wesentlich längere Signale benötigen, als mit den einzelnen Schwingungspaketen vorliegen.

Im Rahmen der vorliegenden Erfindung soll unter einem kurzen Schwingungspaket eines elektrischen Signales ein zeitlich begrenzter Ausschnitt von einigen 10 oder weniger Schwingungen eines schmalbandigen Wechselsignales verstanden werden. Ein derartiges Schwingungspaket wird auch als Burst bezeichnet.

Während die Bestimmung der Frequenz eines längeren, also theoretisch unendlich langen, praktisch mehr als einige hundert Schwingungen andauernden schmalbandigen Wechselsignals in allgemeinen keine Probleme bereitet, erweist sich insbesondere bei höheren Frequenzen die Bestimmung der Frequenz eines nur aus einigen Schwingungen bestehenden Schwingungspakets als aufwendig.

So ist eine Periodendauermessung, also eine Messung der Zeit zwischen zwei ähnlichen Signalpunkten, im allgemeinen den Nulldurchgängen des Signals, nur sinnvoll, wenn die zur Verfügung stehende Zeitbasis wesentlich höherfrequent ist, als die Signalpaketfrequenz. Für eine Mittelwertbildung, wie sie bei leichtem Phasenjitter des Signals erforderlich ist, muß eine externe Schaltung verwendet werden.

Zur Frequenzzählung, also zum Auszählen der Schwingungen in einem Zeitfenster, ist eine schnelle und damit aufwendige Zählerschaltung erforderlich. Eine derartige Zählerschaltung kann, mit zusätzlichem Aufwand, mit einer Einrichtung zur (analogen) Messung des Phasenfehlers zwischen dem Zeitfenster und der Zählschwelle versehen werden.

Darüber hinaus sind Verfahren wie etwa die Fouriertransformation oder die Korrelationsanalyse bekannt, die sowohl recht aussagekräftig als auch rauschtolerant sind, jedoch einen verhältnismäßig hohen Aufwand erfordern.

Weiterhin kann eine Frequenzbestimmung durch einen phasensynchronen Regelkreis (PLL) erfolgen, der jedoch eine hohe Schwingungspaketfolgefrequenz benötigt, wobei die einzelnen Schwingungspaketfrequenzen nicht allzuweit auseinander liegen dürfen. Allerdings kann hierdurch in begrenztem Umfang eine Mittelwertbildung über mehrere Schwingungspakete ohne zusätzlichen Aufwand ermöglicht werden.

Derartige Verfahren beziehungsweise Einrichtungen werden in zahlreichen Gebieten der Technik zur Frequenzbestimmung von Schwingungspaketen eingesetzt. Einer wichtigen Anwendungsbereich stellt die Laser-Doppler-Velocimetrie (LDV) dar. Hierbei wird in der Regel zur Signalauswertung ein Personal-Computer verwendet, der Teile der beschriebenen Auswertungen übernimmt, aber auch zur Bildung des Mittelwertes und verschiedener anderer statistischer Größen aufeinenderfolgender Signalpaketfrequenzen dienen soll.

Aus J. Phys. E. Scientific Instruments, Band 10, Nr. 8, August 1977, Seiten 811-813, ist ein übliches Verfahren zur Bestimmung der Frequenz von LDV-Bursts bekannt, das äußerst schnell arbeitende logische Schaltungen am Eingang erfordert. Ein derartiges Verfahren ist für Frequenzmessungen von LDV-Bursts, deren Dauer erheblich kleiner ist als die am Eingang zu verwirklichende Torzeit, nicht geeignet.

Eine dem vorgenannten Stand der Technik entsprechende Verfahrensweise ist auch aus Review of Scientific Instruments, Band 47, Nr. 6, Juni 1976, Seiten 708-711, bekannt. Auch in dieser Druckschrift wird eine Verfahrensweise zur Verarbeitung von LDV-Bursts beschrieben. Dabei wird ein periodischer Signalzug erzeugt, dessen Frequenz proportional zur Geschwindigkeit der Partikel ist, an denen das Laserlicht gestreut wird. Diese Druckschrift zeigt jedoch gleichfalls, wie oben bereits angedeutet, eine Verfahrensweise, die ungeeignet ist, Frequenzmessungen für LDV-Bursts durchzuführen, deren Dauer erheblich kleiner ist als die Torzeit der Eingangsstufe.

Letztlich ist aus Review of Scientific Instruments, Band 53, Nr. 5, Mai 1982, Seiten 656-661, eine Verfahrensweise zur Ermittlung der Frequenz bzw. der Bewegungsgeschwindigkeit von Teilchen, mittels Laser-Doppler-Anemometrie bekannt. Dabei werden mittels eines Mikroprozessors eine Vielzahl von LDA-Bursts über eine längere Zeit aufgenommen, um anschließend eine statistische Auswertung vorzunehmen, um mehrere Größen, wie z.B. die minimale Geschwindigkeit, die mittlere Geschwindigkeit und die maximale Geschwindigkeit von Teilchen innerhalb eines Meßvolumens zu ermitteln. Dabei ist jedoch eine erhebliche Zeitdauer erforderlich, um zu vertretbaren Ergebnissen zu gelangen.

Der Erfindung liegt die Aufgabe zugrunde, das eingangs genannte, bekannte Verfahren weiterzuentwickeln und ein Verfahren zur Verfügung zu stellen, welches auf möglichst einfache Weise arbeitet.

Diese Aufgabe wird gemäß der Erfindung durch das Verfahren mit den im Patentanspruch 1 aufgeführten Merkmalen gelöst.

Vorteilhafte Ausgestaltungen gehen aus den Merkmalen in den Unteransprüchen hervor.

Das erfindungsgemäße Verfahren ist daher äußerst einfach. Eine beliebige Anzahl von Schwingungspaketen, deren maximale Anzahl lediglich durch die Kapazität der Speichereinrichtung begrenzt wird, wird in der Speichereinrichtung zunächst gesammelt; nach Erreichen der gewünschten Anzahl von Schwingungspaketen werden diese durch zyklisches Auslesen aus dem Speicher wieder verfügbar. Das zyklische Auslesen führt dazu, daß nunmehr zur weiteren Signalverarbeitung nicht mehr nur ein (kurzes) Schwingungspaket zur Verfügung steht, sondern infolge des nahtlos anschließenden wiederholten Auslesens der Schwingungspaketfolge ein prinzipiell beliebig langer Schwingungszug. Dessen mittlere Frequenz läßt sich leicht bestimmen.

Gemäß einer vorteilhaften Ausgestaltung des erfindungsgemäßen Verfahrens ist es noch nicht einmal erforderlich, daß mehrere Schwingungspakete vorliegen, sondern es wird ein einziges Schwingungspaket eingelesen und durch zyklisches Auslesen mit direktem Anschluß der einzelnen Schwingungspakete aneinander eine Schwingungspaketfolge gebildet, die dann, wie voranstehend, angegeben verarbeitet wird.

Damit nicht beispielsweise Störsignale mitverarbeitet werden, welche die Frequenzbestimmung verfälschen könnten, erfolgt Vorteilhafterweise vor dem Einlesen jedes Schwingungspakets eine Überprüfung des Schwingungspakets aufgrund vorher festlegbarer Merkmale, wobei Schwingungspakete mit hiervon abweichenden Eigenschaften vorzugsweise von der Weiterverarbeitung ausgeschlossen werden.

Damit auch während der Einlesezeit ein zyklisches Signal zur Weiterverarbeitung zur Verfügung steht, wird vorteilhafterweise abwechselnd eine Anzahl von Schwingungspaketen eingelesen und eine Anzahl von Schwingungspaketfolgen ausgelesen.

Um die weitere Verarbeitung zu vereinfachen, schlägt eine weitere vorteilhafte Ausgestaltung des erfindungsgemäßen Verfahrens vor, jedes Schwingungspaket vor dem Einlesen in eine serielle Bitfolge zu digitalisieren. Demzufolge erfolgt das Einlesen vorzugsweise seriell, auch das Auslesen kann jedoch ebenso auf serielle Weise erfolgen.

Die Einfachheit des erfindungsgemäßen Verfahrens im Vergleich zu den eingangs genannten Verfahren wird besonders deutlich, wenn die Bestimmung der Frequenz der aneinander angeschlossenen Schwingungspaketfolgen auf analoge Wiese erfolgt. Diese analoge Frequenzbestimmung ist sogar mit einem einfachen Tiefpaß möglich.

Das erfindungsgemäße Verfahren kann sich bspw. einer Einrichtung zur Bestimmung der Frequenz kurzer Schwingungspakete elektrischer Signale bedienen, welche eine Einleseeinrichtung für ein oder mehrere Schwingungspakete aufweist, welcher eine Speichereinrichtung nachgeschaltet ist, aus der in Reaktion auf ein hieran angeschlossenes Steuerwerk die Schwingungspakete aufeinanderfolgend zyklisch wiederholt auslesbar und einer Verarbeitungseinheit, die an die Speichereinrichtung angeschlossen ist, zur Frequenzbestimmung zuführbar sind.

Ein derartige Einrichtung besteht aus nur wenigen und dazu noch wenig aufwendigen Bauteilen. Die Einrichtung läßt sich daher einfach miniaturisieren und, etwa für den Einsatz als Handgerät, insgesamt auf einer einzigen sogenannten Europa-Platine anordnen.

Die bereits im Zusammenhang mit den erfindungsgemäßen Verfahren genannten Vorteile können an einer derartigen Einrichtung nur Geltung gebracht werden.

So ist vorteilhafterweise der Einleseeinrichtung eine Wandlereinrichtung vorgeschaltet, welche die Schwingungspakete jeweils in serielle digitale Schwingungpakete umwandelt.

Eine besonders einfache serielle Verarbeitung des Einlesevorgangs ergibt sich, wenn zwischen Einleseeinrichtung und Speichereinrichtung ein Schieberegister vorgesehen ist. Derselbe Vorteil in noch weitergehender Vereinfachung läßt sich erzielen, wenn auch oder alternativ zwischen Speichereinrichtung und Verarbeitungseinheit ein Schieberegister vorgesehen ist. Insbesondere ist darauf hinzuweisen, daß das die Verarbeitungsfrequenz bestimmende Bauteil nur das zwischen Einleseeinrichtung und Speichereinrichtung, also im Einleseteil, vorgesehene Schieberegister ist, dessen Schiebetakt die Abtast-Frequenz festlegt, sämtliche anderen Bauteile brauchen keinen hohen Anforderungen an die Geschwindigkeit zu entsprechen.

Die Verarbeitungseinheit zur Frequenzbestimmung kann, wie bereits erwähnt, analog arbeiten, also eine analoge Verarbeitungseinheit sein, die sich besonders einfach als Tiefpaß realisieren läßt.

Zur Überprüfung der Schwingungspakete auf vorher festlegbare Merkmale vor dem Einlesen ist vorzugsweise der Einleseeinrichtung eine weitere Einrichtung, die zur Überprüfung dient, vorgeschaltet; die Merkmale können etwa extern vorgegeben und vorzugsweise auch entsprechend dem Einsatzzweck variiert werden.

Um ein gleichzeitiges Einlesen und Auslesen zu ermöglichen, weist die Speichereinrichtung vorzugsweise einen ersten Speicher und einen zweiten Speicher auf, die abwechselnd ein- und auslesen.

Die Erfindung wird nachstehend anhand zeichnerisch dargestellter Ausführungsbeispiele näher erläutert, aus welchen weitere Vorteile und Merkmale hervorgehen.

Es zeigen:
- Fig. 1: die grundsätzliche Wirkungsweise der vorliegenden Erfindung;
- Fig. 2: eine erste Ausführungsform einer Einrichtung, auf der das erfindungsgemäße Verfahren durchführbar ist;
- Fig. 3: eine weitere Auführungsform einer Einrichtung, auf der das erfindungsgemäße Verfahren durchführbar ist;
- Fig. 4: eine weitere Ausführungsform einer Einrichtung, auf der das erfindungsgemäße Verfahren durchführbar ist, wobei Fig. 4a die gewünschte Wirkungsweise charakterisiert, Fig. 4b die eigentliche Ausführungsform der Spannungs-Frequenzwandlung angibt, und Fig. 4c eine andere Spannungs-Frequenz-Wandlung; und
- Fig. 5: eine weitere Ausführungsform einer Einrichtung, auf der das erfindungsgemäße Verfahren ausführbar ist.

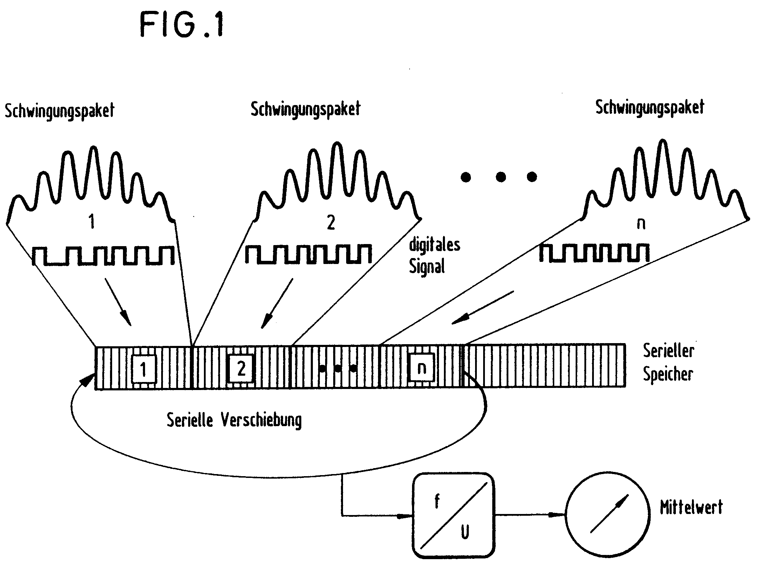

Figur 1 beschreibt die Grundidee des erfindungsgemäßen Verfahrens beziehungsweise der entsprechend arbeitenden Einrichtung. Eine beliebige Anzahl "n" von statistisch aufeinanderfolgenden Schwingungspaketen (Bursts) wird digitalisiert, wobei nur deren Wechselanteil, nicht jedoch deren sich ändernder Offset interessiert. Diese digitalisierten Signale werden nacheinander, das heißt ohne Berücksichtigung der Pausen zwischen den Bursts, in einen seriellen Speicher geschrieben. Dieser serielle Speicher kann in der Praxis beispielsweise als langes Schieberegister realisiert werden. Nachdem die n Bursts abgespeichert sind, wird die abgespeicherte serielle Bitfolge wieder so ausgegeben, wie sie im Speicher vorliegt. Dies geschieht derart, daß nach Auslesen des letzten Bit des n-ten Bursts ohne Unterbrechung mit dem ersten Bit des ersten Bursts der Auslesevorgang fortgeführt wird. Der nicht beschriebene ("leere") Rest des Speichers wird nicht berücksichtigt. Dieses zyklische Auslesen der aneinandergereihten Bursts geschieht beliebig lange, und so entsteht aus einer Anzahl n von endlichen Schwingungszügen ein "unendlicher" Schwingungszug. Dieses Signal kann einer beliebigen Schaltung zur Bestimmung der Frequenz zugeführt werden. Als besonders einfache Möglichkeit hierzu bietet sich, wie in Figur 1 schematisch angedeutet ist, eine Frequenz-Spannungswandlung an; die sich hierbei ergebende Spannung ist der mittleren Signalfrequenz proportional und kann direkt angezeigt werden.

Es wird daher in vorteilhafter Weise mit vergleichsweise geringem Aufwand der Mittelwert der Signalfrequenz einer Burstfolge ermittelt. Dies hat auch Auswirkungen auf die notwendige Abtastung bei der Analog-Digitalwandlung der Bursts. Geht bei dem bisherigem Verfahren der Digitalisierungsfehler bei der Abtastung eines Bursts in das Ergebnis der vor der Mittlung vorgenommenen Frequenzbestimmung direkt ein, so mittelt sich bei dem erfindungsgemäßen Verfahren der Digitalisierungsfehler heraus, da die Frequenzbestimmung nach der Mittelwertbildung erfolgt.

Hierfür besteht lediglich die Voraussetzung, daß eine genügend große Anzahl von Bursts für die Mittlung verwendet wird, und weiterhin die Burstfolge nicht mit dem Abtasttakt korreliert ist. Beide Voraussetzungen sind in der Laser-Doppler-Velocimetrie (LDV) erfüllt; für eine statistisch relevante Mittlung ist nämlich immer eine größere Zahl von Einzelereignissen erforderlich, und die Burstfolge ist zufällig. Daher kann eine Abtastung bis zu Frequenzen nahe der Nyquistgrenze erfolgen, oder es wird eine niedrigere Abtastfrequenz benötigt als in herkömmlichen Systemen.

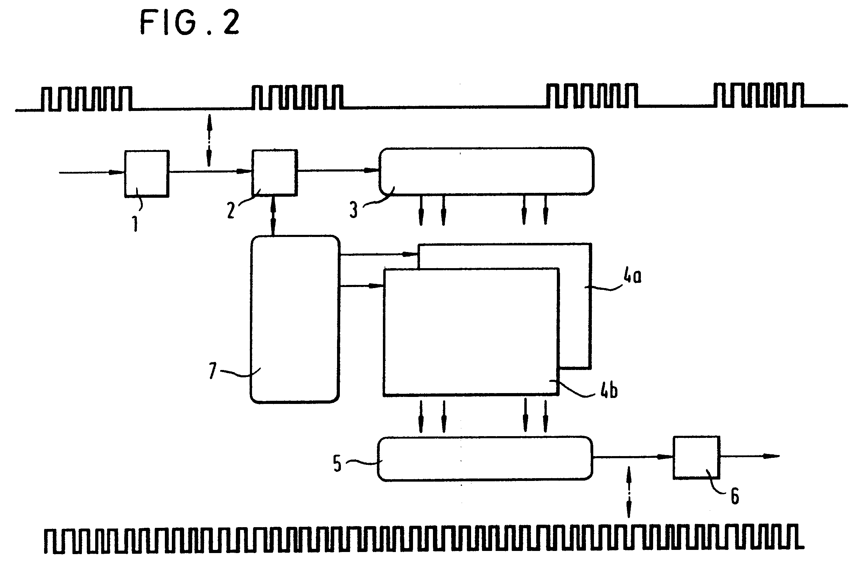

Figur 2 zeigt eine Ausführungsform einer Einrichtung, auf der das erfindungsgemäße Verfahren durchführbar ist. In der oberen Hälfte von Figur 2 sind vier getrennte Signalpakete (Bursts) dargestellt, und die unterschiedlichen Abstände der Signalpakete verdeutlichen, daß die einzelnen Signalpakete statistisch ankommen, das heißt unabhängig voneinander sind. Wie durch den oberen gestrichelten Doppelpfeil in Figur 2 angedeutet ist, liegen die Signalpakete in serieller digitaler Form vor.

Die dargestellten Signalpakete ergeben sich daher durch eine entsprechende Wandlung eines nicht dargestellten Eingangssignals, also einer Anzahl von Signalpaketen, in einer Wandlereinrichtung 1.

Die digitalisierten Signalpakete werden einer Einleseeinrichtung 2 zugeführt und, gesteuert von einem an die Einleseeinrichtung 2 angeschlossenen Steuerwerk 7, einem Schieberegister 3 zugeführt.

Die Einleseeinrichtung 2 kann eine weitere Einrichtung enthalten, in welcher eine Signalanalyse durchgeführt wird, um etwa Störsignale anhand durch das Steuerwerk 7 vorgebbarer Kriterien ausscheiden zu können, so daß nur Signalpakete, die innerhalb des vorgegebenen Merkmalsrahmens liegen, an das Schieberegister 3 übergeben werden.

Zum Speichern der vom Schieberegister 3 ausgegebenen Signalpakete sind zwei Speicher 4a, 4b vorgesehen, die sich beim Ein- und Auslesen abwechseln; jeder Speicher 4a, 4b dient daher sowohl zum Ein- als auch zum Auslesen. Während der erste Speicher, beispielsweise der Speicher 4a, neue Daten (Bursts) einliest, übergibt der zweite Speicher, beispielsweise der Speicher 4b, seine zyklisch ausgelesene Bitfolge der weiteren Auswertung. Das serielle Auslesen, nun aber in zyklischer Folge, erfolgt in einem zweiten Schieberegister 5. In einer dem Schieberegister 5 nachgeschaltetem Einheit 6 erfolgt dann die weitere Auswertung.

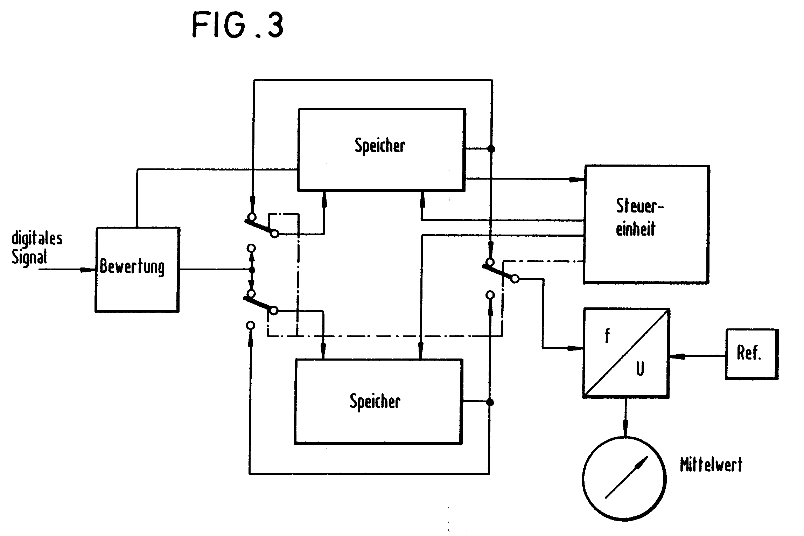

Bei der in Figur 3 dargestellten Ausführungsform einer zur Durchführung des erfindungsgemäßen Verfahrens geeigneten Einrichtung ist dies noch einmal genauer dargestellt. Das eingehende digitale Signal wird einer Bewertung unterworfen und dann auf einen von zwei Speichern gegeben. Bei der in Figur 3 dargestellten Schaltungsanordnung stehen die Schalter gerade so, daß der obere Speicher zyklisch ausliest und der untere Speicher die ankommenden Daten übernimmt. Die beiden Speicher sind erforderlich, da das Auslesen aus dem Speicher erst erfolgen kann, wenn sämtliche n Bursts vorliegen, und bei Vorhandensein nur eines Speichers bei jedem Einlesezyklus die Ausgabe somit unterbrochen würde. Eine analoge Frequenz-Spannungswandlung, wie sie in Figur 3 angedeutet ist, würde dann nicht funktionieren.

Während daher der untere Speicher in Figur 3 neue Daten einliest, übergibt der obere Speicher seine zyklisch ausgelesene Bitfolge an die weitere Auswertung. Die Umschaltung der Schalter erfolgt synchron zum Auslesetakt, so daß die nachfolgende Auswerteschaltung immer einen kontinuierlichen Datenstrom zur Verfügung hat.

Die beiden Speicher gemäß Figur 2 oder 3 lassen sich technisch durch sogenannte FIFOs mit jeweils 18 kBit Speicherkapazität realisieren, die so beschaltet werden können, daß sie sich nach außen wie normale Schieberegister verhalten. Eine Steuerschaltung besorgt die Signalzuordnung zu den einzelnen Schaltungsteilen beziehungsweise das Löschen des Einlesespeichers bei Eintreffen eines gestörten Bursts, was durch aie Bewertungsschaltung festgestellt wird.

Die Weiterverarbeitung der aus dem oberen oder unteren Speicher in Figur 3 ausgelesenen Bitfolge erfolgt, wie bereits beschrieben, durch eine Frequenz-Spannungswandlung und nachfolgende Anzeige eines Mittelwerts der sich so ergebenden Spannung, die daher der Frequenz proportional ist.

Figur 4a verdeutlicht die gewünschte Wandlung eines am Eingang einer Einrichtung anliegenden Frequenzsignals, das in eine der Frequenz proportionale Spannung gewandelt werden soll.

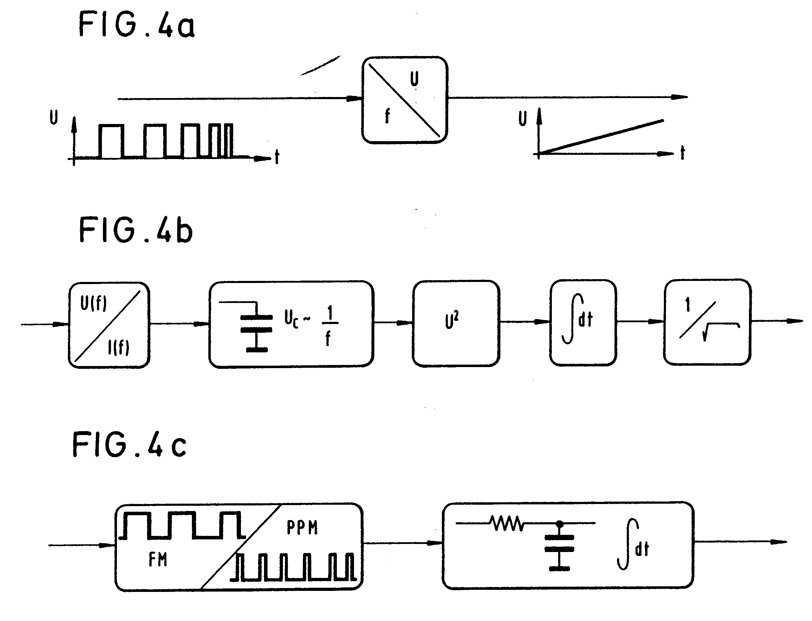

In Figur 4b ist eine Möglichkeit für die Frequenz-Spannungswandlung angedeutet. Das als Spannungssignal vorliegende Frequenzsignal wird in ein Stromsignal umgeformt und einem Kondensator aufgeprägt. Die dem Kondensator abgreifbare Spannung ist der Frequenz umgekehrt proportional. Das gewünschte Ausgangssignal wird durch Bildung des Effektivwertes der Spannung erhalten, also im einzelnen durch Quadrieren, Integrieren beziehungsweise Mittelwertbildung, Radizieren, und anschließende Kehrwertbildung.

Zwar sind integrierte Schaltungen zur Bildung von Effektivwert und Kehrwert erhältlich, allerdings mit dem Nachteil behaftet, daß nur zu niedrige Frequenzen behandelt werden können. Bei geringen Dynamikanforderungen kann der Spannungs-Stromwandler einfach durch einen Widerstand angenähert werden. Dies führt dann zu einem einfachen RC-Glied in Form eines Tiefpasses. Durch Vertauschen der beiden Elemente zur Anordnung als Hochpaß kann die nachfolgende Kehrwertbildung entfallen.

Figur 4c stellt eine Möglichkeit zur technischen Realisierung der für die geforderten Frequenzen benötigten Frequenz-Spannungswandlung dar. Zunächst wird ein FM-Signal (frequenzmoduliert) in ein PPM-Signal (Puls-Phasen moduliert) umgewandelt. Eine derartige Umwandlung kann einfach durch ein D-Flipflop durchgeführt werden, wobei das FM-Signal den Takteingang steuert, während der Clear- (oder alternativ der Preset-) Eingang vom Systemtakt der Schaltung gesteuert wird. Nach der FM-PPM-Wandlung erfolgt eine einfache Integration an einem RC-Glied in Form eines Tiefpasses. Da das Ergebnis nach der Integration am Tiefpaß auch von der Höhe der PPM-Impulse abhängt, sind diese - etwa über einen zusätzlichen schnellen Schalter - von einer Referenzspannung abzuleiten.

Wird die in Figur 3 beschriebene Ausführungsform der Erfindung nicht als integrierte Schaltung (ASIC) ausgeführt, so entsteht ein verhältnismäßig hoher Kostenaufwand für die FIFOs, und außerdem lassen diese kein Löschen selektiver Bereiche zu, beispielsweise des Bereiches mit dem letzten eingelesenen Burst. Bei einem gestörten Burst muß also jedesmal der komplette Speicher mit allen bisher eingelesenen Bursts gelöscht werden.

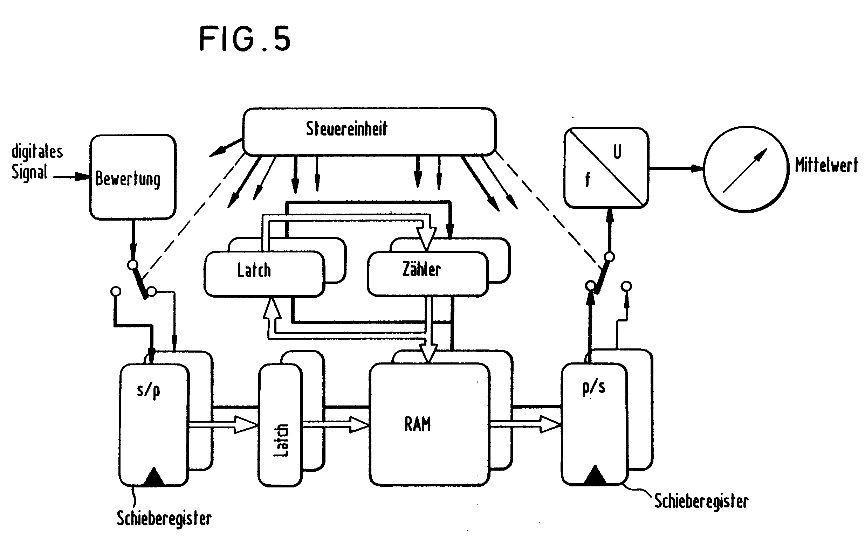

Figur 5 erläutert eine Ausführungsform der zur Durchführung des erfindungsgemäßen Verfahrens geeigneten Einrichtung, bei welcher derartige Probleme nicht bestehen. Bei der in Figur 5 dargestellten Schaltungsanordnung sind zwei parallele RAMs vorgesehen. Die Schaltungsanordnung weist zwei identische Signalpfade auf, jeweils zum abwechselnden Ein- und Auslesen. Die serielle Signalfolge wird durch ein schnelles Schieberegister geringer Länge geführt, beispielsweise von 8 oder 16 Bit. Die Daten werden diesem Schieberegister parallel entnommen und über einen schnellen Zwischenspeicher (Latch) einem gewöhnlichen parallelen RAM zugeführt. Dessen Adreßzähler kann bei Bedarf mit Hilfe eines Zwischenspeichers auf den Wert des letzten Bursts oder einen anderen Wert geladen werden, womit ein selektives Löschen möglich ist. Die Ausgabe der zyklisch ausgelesenen Werte erfolgt über ein Schieberegister, das parallel geladen wird. Der Auslesetakt braucht nicht so schnell zu sein wie der Einlesetakt.

Statt der bei den vorstehenden Ausführungsbeispielen eingesetzten Ein-Bit-Digitalisierung kann auch eine Digitalisierung mit Amplitudenauflösung (beispielsweise 4 Bit) vorgenommen werden, wobei die einzelnen Bits im Prinzip in parallelen Signalpfaden gespeichert werden, pro Bit ein zweifacher Signalpfad, entsprechend der voranstehenden Beschreibung. Das Signal kann dann beim Auslesen wieder amplitudengetreu zusammengesetzt werden.

## Patentansprüche

1. Verfahren zur Bestimmung der mittleren Frequenz periodischer elektrischer Signale innerhalb kurzer, statistisch unabhängig aufeinanderfolgender Schwingungspakete mit Hilfe von Komponenten, die für die Frequenzbestimmung zeitlich wesentlich längere Signale benötigen, als mit den einzelnen Schwingungspaketen vorliegen, wobei das Verfahren die folgenden Schritte aufweist:
(a) Einlesen einer gewünschten Anzahl der Schwingungspakete in eine Speichereinrichtung,
(b) Auslesen der Schwingungspakete aus der Speichereinrichtung derart,
(c) daß die Schwingungspakete in der Reihenfolge des Einlesens zur Erzeugung einer Schwingungspaketfolge unmittelbar aneinander anschließen,
(d) und daß ein zyklisch wiederholtes Auslesen der Schwingungspaketfolge stattfindet,
(e) wobei die Schwingungspaketfolgen unmittelbar aneinander angeschlossen werden,
(f) bis eine vorher festlegbare Anzahl von Auslesezyklen erreicht ist, und
(g) Bestimmung der Frequenz der somit zeitkontinuierlich und gemäß (f) vorgegebenen zyklischen Abfolge der Signalperioden der Schwingungspaketfolge.

2. Verfahren nach Anspruch 1, dadurch **gekennzeichnet,** daß die Anzahl der Schwingungspakete Eins ist.

3. Verfahren nach Anspruch 1 oder 2, dadurch **gekennzeichnet,** daß vor dem Einlesen jedes Schwingungspakets eine Überprüfung des Schwingungspakets nach vorher festlegbaren Merkmalen erfolgt.

4. Verfahren nach einem der Ansprüche 1 bis 3, dadurch **gekennzeichnet,** daß abwechselnd eine Anzahl von Schwingungspaketen eingelesen und eine Anzahl von Schwingungspaketfolgen ausgelesen wird.

5. Verfahren nach einem der Ansprüche 1 bis 4 dadurch **gekennzeichnet,** daß jedes Schwingungspaket vor dem Einlesen in eine serielle Bitfolge digitalisiert wird.

6. Verfahren nach einem der Ansprüche 1 bis 4, dadurch **gekennzeichnet,** daß das Einlesen und/oder Auslesen seriell erfolgt.

7. Verfahren nach einem der Ansprüche 1 bis 6, dadurch **gekennzeichnet,** daß die Bestimmung der Frequenz der aneinander angeschlossenen Schwingungspaketfolgen auf analoge Weise erfolgt.

8. Verfahren nach Anspruch 7, dadurch **gekennzeichnet,** daß die Frequenzbestimmung mit einem RC-Glied erfolgt.

## Claims

1. A method of determining the middle frequency of periodic electric signals within short statistically-independent successive bursts of electric signals by means of components which require for frequency determination signals substantially longer in time than are present with the individual bursts of electric signals, the method comprising the following steps:
(a) a required number of bursts of electric signals are read into a storage device,
(b) the bursts of electric signals are read out of the storage device in such a way
(c) that the bursts of electric signals immediately succeed one another in the sequence of reading-in, to produce a sequence of bursts of electric signals,
(d) and a cyclically repeated reading-out of the sequence of bursts of electric signals takes place,
(e) the sequences of bursts of electric signals immediately succeeding one another
(f) until a predeterminable number of read-out cycles has been reached, and
(g) the frequency is determined of the cyclic sequence of the signal periods of the sequence of bursts of electric signals, which is therefore presented continuously in time and in accordance with (f).

2. A method according to claim 1, characterized in that the number of bursts of electric signals is one.

3. A method according to claims 1 or 2, characterized in that prior to the reading-in of each burst of electric signals, said burst is checked for previously determinable features.

4. A method according to one of claims 1 to 3, characterized in that alternately a number of bursts of electric signals is read in and a number of sequences of bursts of electric signals is read out.

5. A method according to one of claims 1 to 4, characterized in that prior to reading-in, each burst of electric signals is digitalized into a serial sequence of bits.

6. A method according to one of claims 1 to 4, characterized in that the reading-in and/or reading-out is performed serially.

7. A method according to one of claims 1 to 6, characterized in that the frequency of the sequences of bursts of electric signals immediately succeeding one another is determined in analog manner.

8. A method according to claim 7, characterized in that the frequency is determined with an RC-section.

## Revendications

1. Méthode pour déterminer la fréquence moyenne de signaux électriques périodiques au sein de paquets de vibrations courtes et se succédant indépendamment au plan statistique, à l'aide de composants qui nécessitent pour le calcul de la fréquence des signaux nettement plus longs dans le temps que ceux présents avec chacun des paquets de vibrations, la méthode présentant les étapes suivantes :
(a) mémorisation d'un nombre souhaité de paquets de vibrations dans un dispositif à mémoire,
(b) extraction des paquets de vibrations du dispositif à mémoire de telle façon
(c) que les paquets de vibrations se suivent immédiatement dans l'ordre de succession de la mise en mémoire pour générer une séquence de paquets de vibrations,
(d) et qu'on ait une extraction à répétition cyclique de la séquence de paquets de vibrations,
(e) les séquences de paquets de vibrations se succédant immédiatement,
(f) jusqu'à ce qu'un nombre de cycles d'extraction prédéfini soit atteint, et
(g) calcul de la fréquence de la succession cyclique des périodes de signal de la séquence de paquets de vibrations, succession qui est prédéterminée de façon continue dans le temps et selon (f).

2. Méthode selon la revendication 1, caractérisée en ce que le nombre des paquets de vibrations est égal à un.

3. Méthode selon la revendication 1 ou 2, caractérisée en ce que, avant la mémorisation de chaque paquet de vibrations, un contrôle du paquet de vibrations intervient en fonction de caractéristiques qui peuvent être préalablement définies.

4. Méthode selon l'une des revendications 1 à 3, caractérisée en ce que, en alternance, on mémorise un nombre de paquets de vibrations et on extrait un nombre de séquences de paquets de vibrations.

5. Méthode selon l'une des revendications 1 à 4, caractérisée en ce que chaque paquet de vibrations est numérisé avant la mémorisation en une séquence sérielle de bits.

6. Méthode selon l'une des revendications 1 à 4, caractérisée en ce que la mémorisation et/ou l'extraction s'effectuent en série.

7. Méthode selon l'une des revendications 1 à 6, caractérisée en ce que le calcul de la fréquence des séquences de paquets de vibrations raccordées les unes aux autres se fait de manière analogique.

8. Méthode selon la revendication 7, caractérisée en ce que le calcul de la fréquence se fait avec un circuit RC.
